# EUROPEAN PATENT APPLICATION

(11) **EP 4 386 110 A1**
(43) Date of publication of application: **19.06.2024**
(21) Application number: 22214362.0
(22) Date of filing: 16.12.2022
(51) Int. Cl.: C23C 30/00, C23C 28/00, C23C 28/04

(54) **A COATED CUTTING TOOL**

(71) Applicant: AB Sandvik Coromant, 811 81 Sandviken (SE)
(72) Inventor: Schramm, Isabella, 811 81 Sandviken (SE); Johnson, Lars, 811 81 Sandviken (SE)
(74) Representative: Sandvik

(57) **Abstract**

The invention relates to a coated cutting tool (1) comprising a substrate (5) and a coating (6), wherein the coating (6) comprises a nano-multilayer (8) consisting of alternating layers of
i) a first nanolayer (9) of Ti₁-_{X}Al_{X}N, wherein 0.63≤ x ≤0.95, and
ii) a second nanolayer (10) of Cr₁-_{y}Al_{y}N, wherein 0.5≤ y ≤ 0.9
wherein a sequence of one first nanolayer (9) and one second nanolayer (10) forms a layer period, wherein
a) the layer period of the nano-multilayer (8) has an average thickness ≤ 16 nm and ≥ 2 nm,
b) the thickness of the nano-multilayer (8) ranges from 150 nm to 10 µm; and
c) the peak intensity ratio of I(200)/I(111) as measured by XRD on the flank face is >1.

## Description

### Background of the invention

Nano-multilayered coatings are commonly used in the field of cutting tools for metal machining. In these coatings, at least two alternating layers which are different in some respect form a coating of a stack of nanolayers. Metal machining operations include for example turning, milling, and drilling.

In order to provide a long tool life, a coated cutting tool such as an insert should have high resistance against different types of wear. Different metal machining operations affect coated cutting tools in different ways. Turning, for example, is a continuous metal machining operation while milling is more intermittent in nature. In milling, the thermal load will vary over time whereby thermal tensions are induced which may lead to so-called thermal cracks, herein referred to as "comb cracks", in coatings. Increasing the comb crack resistance is thus of great importance to increase the tool lifetime.

Also, mechanical load may lead to fatigue in the cutting edge leading to chipping whereby small fragments of the cutting edge may come loose from the rest of the substrate. A sufficient toughness of the coating, in particular at the cutting edge, may reduce such chipping.

There is thus an object of the present invention to provide a coated cutting tool with high resistance against comb cracks while still providing an acceptable or high level of edge line toughness.

### The invention

The present invention relates to a coated cutting tool comprising a substrate and a coating, wherein the coating comprises a nano-multilayer consisting of alternating layers of
i) a first nanolayer of Ti₁-_{X}Al_{X}N, wherein 0.63≤ x ≤0.95, and
ii) a second nanolayer of Cr₁-_{y}Al_{y}N, wherein 0.5≤ y ≤ 0.9
wherein a sequence of one first nanolayer and one second nanolayer forms a layer period, wherein
a) the layer period of the nano-multilayer has an average thickness ≤ 16 nm and ≥ 2 nm
b) the thickness of the nano-multilayer ranges from 150 nm to 10 µm; and
c) the peak intensity ratio of I(200)/I(111) as measured by θ-2θ X-Ray-Diffraction (XRD) on the flank face is >1.

In accordance with the present invention, the analysis by means of θ-2θ XRD of the TiAIN layer on the flank face should be made at a distance from the cutting edge but still in a region close to the cutting edge which is of relevance during metal machining. Thus, the analysis on the flank face is made at a position of about 150 to 300 µm, preferably at about 200 µm distance from the surface plane of a rake face. Also, there should be a distance of at least 1 mm away from any other flank face.

According to one embodiment, the peak intensity ratio of I(200)/I(111) as measured by θ-2θ XRD on the flank face is >1.5, preferably > 4, and more preferably > 5. It is to be noted that the peak intensity ratio can be infinite or at least very high when the I(111) is zero or very low.

According to one embodiment, 0.65≤ x ≤0.95, preferably 0.67≤ x ≤0.95 or 0.70≤ x ≤0.95 or 0.72≤ x ≤0.95 or 0.75≤ x ≤0.90 or 0.78≤ x ≤0.85.

According to one embodiment, 0.55 ≤ y ≤ 0.80, preferably 0.6≤ y ≤ 0.8, or more preferably 0.65≤ y ≤ 0.75.

According to one embodiment, the average layer period thickness in the nano-multilayer ≤ 14 nm and ≥ 2 nm, preferably ≤ 12 nm and ≥ 2 nm, and most preferably ≤ 10 nm and ≥ 3 nm or ≤ 8 nm and ≥ 4 nm.

According to one embodiment, the nano-multilayer has a thickness ranging from 0.2 µm to about 10 µm such as from 0.3 µm to about 10 µm, preferably from about 0.5 to about 10 µm, or 1 µm to 7 µm, or 2 µm to 7 µm.

According to one embodiment, the nano-multilayer is deposited directly on the substrate.

According to one embodiment, the nano-multilayer is the outermost layer of the coating.

According to one embodiment, the nano-multilayer is a cathodic arc evaporation deposited layer.

According to one embodiment, the coating comprises an inner layer of TiN, (Ti,AI)N or (Cr,AI)N, preferably (Ti,AI)N, between the substrate and the nano-multilayer.

The thickness of the inner layer can range from about 0.1 to 10 µm, for example 0.1 to 5 µm or 0.1 to about 2 µm, preferably from about 0.5 to about 1.5 µm.

According to one embodiment, if the coating comprises a (Ti,AI)N layer as an inner layer, then the (Ti,AI)N is suitably Ti_{1-z}Al_{z}N, wherein 0.35≤z≤0.70, preferably 0.45≤z≤0.70.

According to one embodiment, the Ti-AI relation in the (Ti,AI)N inner layer is the same as the Ti-AI relation in the first nanolayer of the nano-multilayer.

According to one embodiment, no inner layer is deposited between the substrate and the nano-multilayer.

According to one embodiment, the coating comprises an outer layer on the nano-multilayer. The outer layer may be for example a layer of (Ti,AI)N, (Cr,AI)N, (Ti,Si)N, or (Ti,Al,Si)N.

According to one embodiment, no further layer is deposited on the nano-multilayer.

According to one embodiment, the substrate of the coated cutting tool is selected from the group of cemented carbide, cermet, ceramic, cubic boron nitride and high speed steel. In one embodiment, the substrate is a cemented carbide comprising from 5 to 18 wt% Co and from 0 to 10 wt% carbides, nitrides or carbonitrides of group 4 to 5 in the periodic table of elements. Further, components like Cr may be comprised in the cemented carbide substrate. The coated cutting tool is suitably a cutting tool insert, a drill, or a solid end-mill, for metal machining. The cutting tool insert is, for example, a turning insert or a milling insert.

### Definitions

By the term "average layer period thickness" is meant the average thickness of a combination A-B in the nano-multilayer coating of a first nanolayer A and a second nanolayer B in a nano-multilayer A-B-A-B-A....

The average layer period thickness can be calculated by means of TEM analysis of a cross-section of the nano-multilayer and by counting the number of consecutive A-B nanolayer periods over a length of at least 200 nm or for layer thicknesses below 200 nm, the entire nano-multilayer coating thickness, to arrive at an average value.

### Methods

X-ray Diffraction: θ-2θ X-ray diffraction (XRD) analysis was conducted on the flank face as specified herein close to the cutting edge of the coated inserts using a Bruker D8 Discover diffractometer equipped with a 2D detector (VANTEC-500) and a IµS X-ray source (Cu-K_{á}, 50.0 kV, 1.0 mA) with an integrated parallel beam Montel mirror. The coated cutting tool inserts were mounted in sample holders that ensure that the flank face of the samples was parallel to the reference surface of the sample holder and also that the flank face was at an appropriate height. The diffracted intensity from the coated cutting tool was measured around 2θ angles where relevant peaks occur, so that at least 20° to 80° were included. Data analysis, including background subtraction and Cu-K_{α2} stripping, was performed using PANalytical's X'Pert HighScore Plus software. A Pseudo-Voigt-Fit function was used for peak analysis. No thin film correction was applied to the obtained peak intensities. Possible peak overlaps of a (200) peak or a (111) peak with any diffraction peak not belonging to the PVD layer, e.g., a substrate reflection like WC, were compensated for by the software (deconvolution of combined peaks) when determining the peak intensities and peak widths.

### Brief descriptions of the drawings

Figure 1 shows a schematic view of one embodiment of a cutting tool being a milling insert.
Figure 2 shows a coated cutting tool.
Figure 3 shows the region for performing measurements close to the cutting edge.
Figure 4 shows the results in relation to a reference Ti₄₀Al₆₀N layer.

### Detailed description of embodiments in drawings

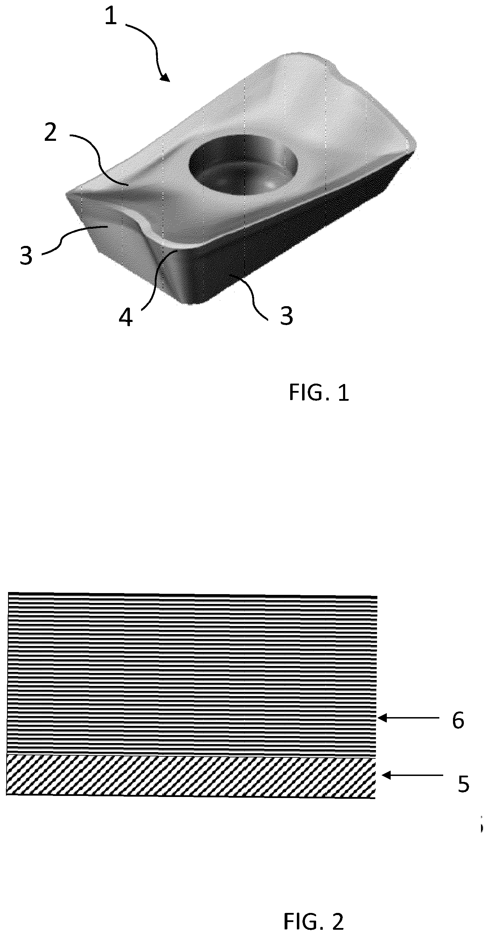

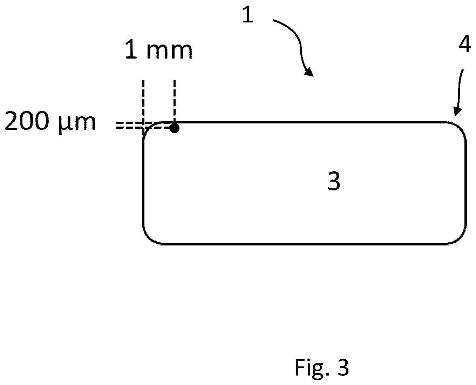

Figure 1 shows a schematic view of one embodiment of a cutting tool 1 having a rake face 2, a flank face 3 and a cutting edge 4. The cutting tool 1 is in this embodiment a milling insert. Figure 2 shows a schematic view of a cutting tool comprising a substrate 5 and a nano-multilayer 6 coated on the substrate 5. Figure 3 shows schematically a cutting tool 1 viewed from the flank face 3 at which point on the flank face the intensity ratios of I(200)/I(111) and other properties are measured. Figure 3 further shows cutting edges 4.

### Examples

Nano-multilayers of (Cr,AI)N and (Ti,AI)N were deposited on sintered cemented carbide cutting tool insert blanks of the geometries SNMA120408, CNMG120408MM and R390-11. The composition of the cemented carbide was 10 wt% Co, 0.4 wt% Cr and the rest WC. The cemented carbide blanks were coated by cathodic arc evaporation in a PVD vacuum chamber comprising four arc flanges. Three targets of Cr-Al were mounted in three flanges opposite each other and three targets of Ti-AI were mounted in the three remaining flanges opposite each other. The targets were circular and planar with a diameter of 100 mm available on the open market. Suitable target technology packages for arc evaporation are available from suppliers on the market such as IHI Hauzer Techno Coating B.V., Kobelco (Kobe Steel Ltd.) and Oerlikon Metco.

The uncoated blanks were mounted on pins that underwent a three-fold rotation in the PVD chamber.

### Samples 1-6:

The vacuum chamber was pumped down to high vacuum (less than 10⁻² Pa) and heated to 450-550°C by heaters located inside the vacuum chamber. The blanks were then etched for 60 minutes in an Ar plasma.

The chamber pressure (reaction pressure) was set to 4 Pa and 10 Pa of N₂ gas respectively as set out in table 1, and a DC bias voltage of -300 V or -70 V (relative to the chamber walls) was applied to the blank assembly. The cathodes were run in an arc discharge mode at a current of 150 A (each) for 110 minutes (4 flanges). Nano-multilayer coatings having a thickness ranging from 2.4 to 4 µm were deposited on the blanks.

The samples were prepared by depositions with a Cr_{0.30}Al_{0.70} target and the following Ti-Al targets: Ti_{0.33}Al_{0.67}, Ti_{0.29}Al_{0.71}, Ti_{0.25}Al_{0.75}, Ti_{0.20}Al_{0.80}, and Ti_{0.15}Al_{0.85}.

The rotational speed, i.e. 5 rpm of the substrate table, correlates to a certain period thickness as set out in table 1 below. The rotational speed corresponds to the speed at the circumference of the substrate table since the speed depends on the rpm and the diameter of the table. The calculated speed was 0.215 m/s when the rotation speed of the substrate table was 5 rpm and the diameter of the table was 0.82 m. The mounting of the inserts was such that the flank faces of the inserts would directly face the targets during rotation.

**Table 1**

| Sample | Targets | Table rot. speed | Estimated nanolayer period thickness* | First nano-layer** | Second nano-layer** | DC bias volt. | N2 press. | XRD Intensity peak ratio on the flank face I (200) /I(111) the flank face |
|---|---|---|---|---|---|---|---|---|
| 1 (comp. sample) | Ti₂₉Al₇₁/ Cr₃₀Al₇₀ | 5 rpm | 5.2 nm | Ti_{0.33}Al_{0.67}N | Cr_{0.32}Al_{0.68}N | -300 V | 10 Pa | 0.51 |
| 2 (inv) | Ti₁₅Al₈₅/ Cr₃₀Al₇₀ | 5 rpm | 5.4 nm | Ti_{0.19}Al_{0.81}N | Cr_{0.32}Al_{0.68}N | -300 V | 10 Pa | 5.19 |
| 3 (inv) | Ti₂₀Al₈₀/ Cr₃₀Al₇₀ | 5 rpm | 4.8 nm | Ti_{0.24}Al_{0.76}N | Cr_{0.32}Al_{0.68}N | -300 V | 10 Pa | 6.39 |
| 4 (comp. sample) | Ti₃₃Al₆₇/ Cr₃₀Al₇₀ | 5 rpm | 5.2 nm | Ti_{0.37}Al_{0.63}N | Cr_{0.32}Al_{0.68}N | - 300V | 10 Pa | 0.63 |
| 5 (inv) | Ti₂₉Al₇₁/ Cr₃₀Al₇₀ | 5 rpm | 9 nm | Ti_{0.33}Al_{0.67}N | Cr_{0.32}Al_{0.68}N | -70 V | 4 Pa | 4.8 |
| 6 (comp. sample) | Ti₂₅Al₇₅/ Cr₃₀Al₇₀ | 5 rpm | 5.2 nm | Ti_{0.29}Al_{0.71}N | Cr_{0.32}Al_{0.68}N | -300 V | 10 Pa | 0.97 |

| | | | | | | | | |
|---|---|---|---|---|---|---|---|---|
| * total thickness of one nanolayer (Ti,AI)N and one nanolayer (Cr,AI)N ** The atomic percentage of Al in table 1 is based on a loss of 4 atomic% of Al in the (Ti,AI)N nanolayer and a loss of 2 atomic% of Al in the (Cr,AI)N nanolayer with respect to the target compositions indicated in table 1 | | | | | | | | |

In order to confirm the actual elemental composition in the first and second nano-multilayers as presented in table 1, the average composition was analysed using energy-dispersive X-ray spectroscopy (EDS) for some samples. The EDS measurements were made over a distance comprising a number of nanolayers in SEM on a cross-section of the coating.

Deviations of 2-5 percent units from the theoretical compositions, i.e. the target compositions, were noted in general. The EDS measurements were made in SEM on a cross-section of the coating. The actual Al content specified as AI/(Ti+AI) in the (Ti,AI)N layer and the actual Al content specified as AI/(Cr+AI) in the (Cr,AI)N layer thus deviate by about -2 to -5 at% units from the Al content in the targets.

θ-2θ X-ray diffraction (XRD) analysis was conducted on the flank face as specified herein close to the cutting edge of the coated inserts using a Bruker D8 Discover diffractometer equipped with a 2D detector (VANTEC-500) and a IµS X-ray source (Cu-K_{á}, 50.0 kV, 1.0 mA) with an integrated parallel beam Montel mirror. The coated cutting tool inserts were mounted in sample holders that ensure that the flank face of the samples was parallel to the reference surface of the sample holder and also that the flank face was at an appropriate height. The diffracted intensity from the coated cutting tool was measured around 2θ angles where relevant peaks occur, so that at least 20° to 80° were included. Data analysis, including background subtraction and Cu-K_{α2} stripping, was performed using PANalytical's X'Pert HighScore Plus software. A Pseudo-Voigt-Fit function was used for peak analysis. No thin film correction was applied to the obtained peak intensities. Possible peak overlaps of a (200) peak or a (111) peak with any diffraction peak not belonging to the PVD layer, e.g., a substrate reflection like WC, were compensated for by the software (deconvolution of combined peaks) when determining the peak intensities and peak widths.

### Example 2

Cutting tests were made in order to determine the performance of the samples made. The following expressions/terms are commonly used in metal cutting, but nevertheless explained in the below:
- Vc (m/min):: cutting speed in meters per minute
- fz (mm/tooth):: feed rate in millimeter per tooth (in milling)
- fn (mm/rev): feed rate per revolution (in turning)
- z: (number): number of teeth in the cutter
- aₑ (mm):: radial depth of cut in millimeter
- aₚ (mm):: axial depth of cut in millimeter

### Comb crack resistance:

Operation: Shoulder milling
Tool holder: R245-080027-12M, Dc=80mm
Work piece material: Toolox 33 (tool steel), L=600 mm, l=200 mm, h=100 mm
Insert type: R390-11
Cutting speed V_{c}=320 m/min
Feed rate f_{z}=0.3 mm/rev
Depth of cut aₚ=2 mm
Radial engagement aₑ= 15 mm
with cutting fluid
The criteria for end of tool life is a max. chipped height VB>0.3 mm.

### Edge line toughness:

Work piece material: Dievar unhardened, P3. 0.Z.AN,
z=1
V_{c}=200 m/min
f_{z}=0.20 mm
aₑ=12 mm
aₚ=3.0
length of cut=12mm without cutting fluid

The cut-off criteria are chipping of at least 0.5 mm of the edge line or a measured depth of 0.2 mm at either the flank phase or the rake phase. The tool life was presented as the number of cut entrances in order to achieve these criteria.
Operation: Facing (turning)
Work piece material: Bar of austenitic stainless steel Sanmac 316L, L=200 mm, D=100 mm, -215 HB
Insert type: CNMG 120408-MM
Cooling: yes
Depth of cut aₚ = 4 to 0, 0 to 4 mm
Cutting speed V_{c} = 140 m/min
Feed rate f_{z} = 0.36 mm/rev

The comb crack resistance, edge line toughness (ELT), crystal orientation (intensity ratio I(200)/I(111)), and Al content are shown in Table 2.

### Reference sample 7

A reference sample 7 was included in the performance testing consisting of a coated cutting tool made by depositing an about 3 µm thick layer of (Ti,AI)N using a target composition of Ti_{0.40}Al_{0.60}. Sample 7 was used in order to compare data of the samples 1-6 tested in different test runs. Sample 7 was included in all tests and its results were set as "100%". The results of samples 1-6 tested along with the reference sample 7 in a test run were then related to the reference sample 7 by calculating the performance in comb crack resistance and ELT based on the percentage of the result of the reference sample. A performance of 100% was thus equal to the performance of the reference sample 7.

### Preparation of reference sample 7

The (Ti,AI)N layer was deposited on sintered cemented carbide cutting tool insert blanks of the geometries SNMA 120408, CNMG120804-MM and R390-11T308M-PM. By using this reference sample 7 with a TiAIN layer, any kind of possible differences between performance testing runs were compensated for and the results from different test runs could be compared. The composition of the cemented carbide was 10 wt% Co, 0.4 wt% Cr and the rest was WC. The cemented carbide blanks were coated by cathodic arc evaporation in a PVD vacuum chamber comprising four arc flanges, each flange comprising several cathode evaporators.

Targets of Ti_{0.40}Al_{0.60} were mounted in the evaporators in all of the flanges. The targets were circular and planar with a diameter of 100 mm available on the open market. Suitable target technology packages for arc evaporation are available from suppliers on the market such as IHI Hauzer Techno Coating B.V., Kobelco (Kobe Steel Ltd.) and Oerlikon Metco.

**Table 2**

| Samples | Target* (first nano-layer) | Estimated nano-layer periods | Comb crack resistance Number of cuts/ relative performance in view of Ti₄₀Al₆₀N (%) | Edge line toughness Number of cuts/ relative performance in view of Ti₄₀Al₆₀N (%) | XRD Intensity peak ratio on the flank face I(200)/ I(111) | Total thickness of coating on flank face [µm] |
|---|---|---|---|---|---|---|
| 1 (Comp sample) | Ti_{0.29}Al_{0.71} | 5.2 nm | 65% | 554 % | 0.51 | 2.4 |
| 2 (inv) | Ti_{0.15}Al_{0.85} | 5.4 nm | 110% | 320% | 5.19 | 2.5 |
| 3 (inv) | Ti_{0.20}Al_{0.80} | 4.8 nm | 95% | 464% | 6.39 | 2.2 |
| 4 (Comp sample) | Ti_{0.33}Al_{0.67} | 5.2 nm | 73% | 682% | 0.63 | 2.4 |
| 5 (inv) | Ti_{0.29}Al_{0.71} | 9 nm | 126% | 220% | 4.8 | 4.2 |
| 6 (Comp sample) | Ti_{0.25}Al_{0.75} | 5.2 nm | 69% | 500% | 0.97 | 2.4 |
| 7 (Sample reference) | Ti₄₀Al₆₀ | No layer period (single layer) | 100% | 100% | Only 200 peak, no 111 (ratio value is infinite) | 3.0 |

| | | | | | | |
|---|---|---|---|---|---|---|
| *Cr₃₀Al₇₀ target was used in all samples for preparing the second nano-layer | | | | | | |

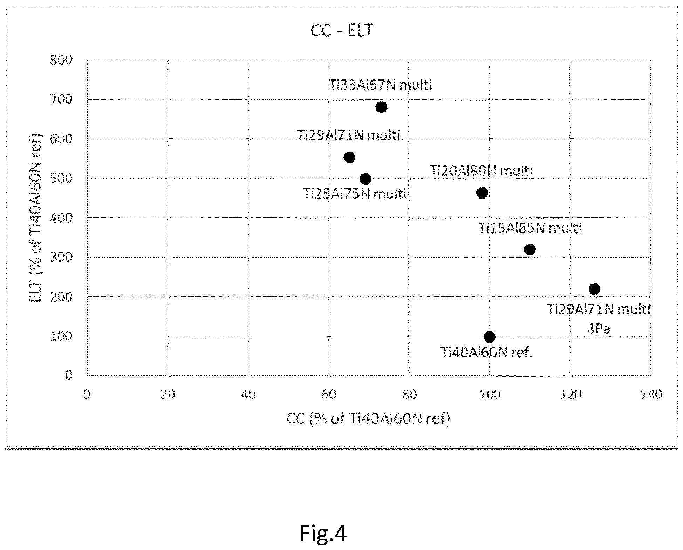

Table 2 shows that in terms of comb crack resistance, improved results were obtained for samples with an intensity ratio I(200)/I(111) > 1 in combination with high Al content in the [Ti, AI]N coating presented as % performance relative to the nitride prepared from the Ti₄₀Al₆₀ target (sample reference). From table 2, it can also be concluded that the samples according to the invention show high or at least acceptable edge line toughness (ELT) while obtaining improved comb crack resistance. The results are also shown in figure 4 illustrating the ELT on the Y axis and the comb crack resistance (CC) on the X axis for all samples based on their performance in relation to the nitride obtained from the Ti₄₀Al₆₀ target. The coatings in figure 4 are, however, presented as nitrides obtained from the relevant (Ti, Al) target without indication of the loss of aluminium content.

## Claims

1. Coated cutting tool (1) comprising a substrate (5) and a coating (6), wherein the coating (6) comprises a nano-multilayer (8) consisting of alternating layers of
i) a first nanolayer (9) of Ti₁-_{X}Al_{X}N, wherein 0.63≤ x ≤0.95, and
ii) a second nanolayer (10) of Cr₁-_{y}Al_{y}N, wherein 0.5≤ y ≤ 0.9
wherein a sequence of one first nanolayer (9) and one second nanolayer (10) forms a layer period, wherein
a) the layer period of the nano-multilayer (8) has an average thickness ≤ 16 nm and ≥ 2 nm,
b) the thickness of the nano-multilayer (8) ranges from 150 nm to 10 µm; and
c) the peak intensity ratio of I(200)/I(111) as measured by θ-2θ X-Ray-Diffraction (XRD) on the flank face is >1.

2. Coated cutting tool (1) according to claim 1, wherein
i) the first nanolayer (9) is Ti₁-_{X}Al_{X}N, wherein 0.65≤ x ≤0.95; and
ii) the second nanolayer (10) is Cr₁-_{y}Al_{y}N, wherein 0.6≤ y ≤ 0.8.

3. Coated cutting tool (1) according to claim 1, wherein
i) the first nanolayer (9) is Ti₁-_{X}Al_{X}N, wherein 0.67≤ x ≤0.95; and
ii) the second nanolayer (10) is Cr₁-_{y}Al_{y}N, wherein 0.6≤ y ≤ 0.8.

4. Coated cutting tool (1) according to claim 1, wherein
i) the first nanolayer (9) is Ti₁-_{X}Al_{X}N, wherein 0.70≤ x ≤0.95; and
ii) the second nanolayer (10) is Cr₁-_{y}Al_{y}N, wherein 0.6≤ y ≤ 0.8.

5. Coated cutting tool (1) according to claim 1, wherein
i) the first nanolayer (9) is Ti₁-_{X}Al_{X}N, wherein 0.72≤ x ≤0.95; and
ii) the second nanolayer (10) is Cr₁-_{y}Al_{y}N, wherein 0.6≤ y ≤ 0.8.

6. Coated cutting tool (1) according to any one of claims 1 to 5, wherein the layer period of the nano-multilayer (8) has an average thickness ≤ 14 nm and --:,> 2 nm.

7. Coated cutting tool (1) according to any one of claims 1 to 6, wherein the layer period of the nano-multilayer (8) has an average thickness ≤ 12 nm and --:,> 2 nm.

8. Coated cutting tool (1) according to any one of claims 1 to 7, wherein the layer period of the nano-multilayer (8) has an average thickness ≤ 10 nm and --:,> 2 nm.

9. Coated cutting tool (1) according to any one of claims 1 to 8, wherein the nano-multilayer (8) has a thickness ranging from 0.5 to 10 µm.

10. Coated cutting tool (1) according to any one of claims 1 to 9, wherein the nano-multilayer (8) is deposited directly on the substrate (5).

11. Coated cutting tool (1) according to any one of claims 1 to 10, wherein a layer of TiN, TiAIN or CrAIN is deposited between the substrate (5) and the nano-multilayer (8).

12. Coated cutting tool (1) according to any one of claims 1 to 11, wherein the nano-multilayer (8) is the outermost layer of the coating (6).

13. Coated cutting tool (1) according to any one of claims 1 to 12, wherein an outer layer selected from TiAIN, CrAIN, TiSiN, or TiAlSiN is deposited on the nano-multilayer (8).
